# EUROPÄISCHE PATENTSCHRIFT

(11) **EP 1 518 006 B1**
(45) Veröffentlichungstag und Bekanntmachung des Hinweises auf die Patenterteilung: **05.10.2005**
(21) Anmeldenummer: 03763647.9
(22) Anmeldetag: 20.06.2003
(51) Int. Cl.: C23C 14/34, H01J 37/34

(54) **TARGETTRÄGERANORDNUNG**
TARGET SUPPORT ASSEMBLY
ENSEMBLE PORTE-CIBLE

(30) Priorität: 10.07.2002 DE 10231203
(43) Veröffentlichungstag der Anmeldung: 30.03.2005
(73) Patentinhaber: INTERPANE Entwicklungs- und Beratungsgesellschaft mbH & Co. KG, D-37697 Lauenförde (DE)
(72) Erfinder: LANDGRAF, Ralf, 94579 Zenting (DE); HERWIG, Wilhelm, 37688 Beverungen (DE)
(74) Vertreter: Körfer, Thomas
(86) Internationale Anmeldenummer: PCT/EP2003/006518
(87) Internationale Veröffentlichungsnummer: WO 2004/007791

(56) Entgegenhaltungen:
- EP-A- 1 225 249
- WO-A-02/20866
- US-A- 5 147 521
- US-A- 5 531 876
- US-A- 5 565 071

## Beschreibung

Die Erfindung bezieht sich auf eine Targetträgeranordnung nach dem Oberbegriff des Anspruchs 1.

Zum Aufbringen einer Beschichtung auf ein im wesentlichen ebenes Substrat ist es bekannt, das Überzugsmaterial durch Kathodenzerstäubung zu zerstäuben und auf dem Substrat abzuscheiden. Dabei bildet ein Targetmantel, der auf einem Tragrohr sitzt und mit diesem eine Targetträgeranordnung. Eine solche Vorrichtung für Kathodenzerstäubung ist z. B. in der EP 0 070 899 B1 beschrieben. Zum Aufbringen des Beschichtungsmaterials auf ein Tragrohr ist es üblich, das Überzugsmaterial durch Flammspritzen umlaufend auf das Tragrohr aufzutragen, wodurch der Targetmantel gebildet wird und mit dem Tragrohr eine unlösbare Einheit bildet. Diese bekannten Maßnahmen sind sowohl zur Bildung des Targetmantels selbst als auch zur Anbringung des Targetmantels am Tragrohr aufwendig.

Der Erfindung liegt die Aufgabe zu Grunde, bei einer Targetträgeranordnung nach dem Oberbegriff des Anspruchs 1 die Herstellung des Targetmantels oder der Targetträgeranordnung und/oder die Anbringung des Targetmantels am Träger zu vereinfachen.

Diese Aufgabe wird durch die Merkmale des Anspruchs 1 gelöst.

Bei der erfindungsgemäßen Targetträgeranordnung ist der Targetmantel durch eine Targethülse gebildet, die auf den Träger aufgeschoben und wärmeleitend sowie elektrisch leitend fixiert ist. Dabei sind zwischen dem Träger und der Targethülse mehrere elastisch wirksame Klemmelemente angeordnet die auf dem umfang verteilt angeordnet sind und jeweils durch eine Feder gebildet sind. Die erfindungsgemäße Targethülse läßt sich im Gegensatz zum Stand der Technik vorfertigen und gegebenenfalls lagern, wobei sie einfach und schnell durch Aufschieben auf den Träger montierbar und gegebenenfalls wieder demontierbar ist. Die Montage kann in einer zugehörigen Vorrichtung zum Zerstäuben des Überzugsmaterials erfolgen, wobei der Träger nur zum Teil demontiert zu werden braucht, nämlich nur soweit, daß die Targethülse von einem Ende her aufschiebbar ist. Die Erfindung ermöglicht somit mehrere Vorteile, die sowohl die Targethülse selbst auch als die Targetträgeranordnung betreffen.

Vorteilhafte Weiterbildungen der Erfindung sind in den Unteransprüchen beschrieben.

Das wenigstens eine elastisch wirksame Klemmelement dient der Fixierung der Targethülse in ihrer Achsrichtung und/oder Umfangsrichtung auf dem Träger. Außerdem kann das elastische Klemmelement einen thermischen Leiter und/oder elektrischen Leiter bilden, wenn es aus wärmeleitendem Material und/oder aus elektrisch leitendem Material besteht. Es sind nach Anspruch 1 mehrere elastisch wirksame Klemmelemente vorzusehen, die vorzugsweise auf dem Umfang verteilt angeordnet sind, wodurch sich die Fixierungskräfte und/oder die Wärmeleitung vergrößern lassen und/oder die elektrische Kontaktierung verbessern läßt.

Es ist vorteilhaft, das wenigstens eine Klemmelement in einer Ausnehmung der Innenmantelfläche der Targethülse oder vorzugsweise der Außenmantelfläche des Trägers so anzuordnen, daß ein Klemmarm des Klemmelements über die Innenmantelfläche bzw. die Außenmantelfläche vorsteht, beim Montieren der Targethülse selbsttätig eingebogen wird und mit einer radialen Spannung an der gegenüberliegenden Außen- bzw. Innenmantelfläche anliegt. Dabei ist es besonders vorteilhaft, die Basis des Klemmelements in der Ausnehmung zu fixieren, so daß es unverlierbar gehalten ist. Das Klemmelement kann zum Beispiel durch einen Winkel gebildet sein, dessen einer Schenkel die Basis des Klemmelements bildet und dessen anderer Schenkel gegen das andere Teil elastisch drückt. Eine einfach und kostengünstige Herstellung ist insbesondere dann möglich, wenn eine oder mehrere Ringnuten oder axial oder wendelförmig verlaufende Nuten vorgesehen sind, in denen mehrere elastisch wirksame Klemmelemente einsetzbar sind.

Zwecks einer guten Wärmeableitung der im Funktionsbetrieb der Targethülse entstehenden Wärme ist es vorteilhaft, das wenigstens eine Klemmelement aus einem elastisch verformbaren Material zu bilden, das im Klemmzustand radial gegen die Targethülse drückt und dabei so weich ist, daß es sich flächig an die Targethülse und seinem Widerlager anlegt, wodurch aufgrund der großen Anlagefläche eine leistungsfähige Wärmeableitung erfolgen kann. Dies gilt sowohl für die Anlage des Klemmelements an der Targethülse als auch am Träger. Vorteilhaft sind solche Materialien, die trotz ihrer elastischen Verformbarkeit bzw. elastischen Komprimierbarkeit elektrisch leitend und wärmeleitend sind. Hierzu eignet sich ein Kunststoff z. B. Silikon, in den elektrisch leitende oder wärmeleitende Partikel oder Elemente, z. B. Fasern, beispielsweise aus Metall oder Kohlenstoff eingebettet sind.

Es ist besonders vorteilhaft, ein Klemmelement in Ringform vorzusehen, das in einer Ringnut in dem das Klemmelement tragenden Bauteil sitzt und dieses Bauteil radial so weit überragt, daß es mit einer radialen Klemmspannung zwischen der Targethülse und dem Träger sitzt. Außerdem ist eine runde Querschnittsform des Klemmelements von Vorteil, weil die in beide Achsrichtungen weisenden Rundungen Einführungsflächen bilden, die beim Aufschieben der Targethülse ein selbsttätiges Ausweichen und elastisches Komprimieren des Klemmelements bewirken. Ein weiterer Vorteil der Ringform besteht darin, daß ein solches Klemmelement aufgrund der Ringform unverlierbar gehalten ist und es deshalb keiner weiteren Haltemittel bedarf.

Die erfindungsgemäße Targethülse braucht in Umfangsrichtung nicht geschlossen zu sein, obwohl die in Umfangrichtung geschlossene Form insbesondere aus Festigkeit- und Haltegründen vorteilhaft ist. Die Targethülse kann deshalb längs geschlitzt sein oder es kann sich um einen in Umfangsrichtung nicht geschlossenen Hülsenabschnitt handeln.

Die Targetträgeranordnung kann eine Rohrkathode in einer Vorrichtung zur Kathodenzerstäubung des Materials der Targethülse sein und in einer Unterdruckkammer der Vorrichtung neben oder über einem Träger für ein Substrat angeordnet sein, auf dem das zerstäubte Material niedergeschlagen wird. Die Targetträgeranordnung eignet sich vorzugsweise zum Niederschlagen einer zerstäubenden Materialschicht auf eine das Substrat bildende Glasscheibe.

Nachfolgend werden vorteilhafte Ausgestaltungen der Erfindung anhand eines bevorzugten Ausführungsbeispiels und der Zeichnung näher erläutert. Es zeigen:
- Fig. 1: ein Ausführungsbeispiel einer erfindungsgemäßen Targetträgeranordnung im axialen Schnitt;
- Fig. 2: die Targetträgeranordnung in der Seitenansicht;
- Fig. 3: zwei unterschiedlich ausgebildete Bereiche eines Trägers der Targetträgeranordnung in der Draufsicht;
- Fig. 4: ein elastisch wirksames Klemmelement in seiner Bereitschaftsstellung als in Fig. 3 mit X gekennzeichnete Einzelheit;
- Fig. 5: das elastisch wirksame Klemmelement in seiner Arbeitsstellung, in der eine Targethülse auf den Träger axial aufgeschoben ist;
- Fig. 6: ein elastisch wirksames Klemmelement in seiner Bereitschaftsstellung als in Fig. 3 mit X gekennzeichnete Einzelheit in abgewandelter Ausgestaltung; und
- Fig. 7: das elastisch wirksame Klemmelement nach Fig. 6 in seiner Klemmstellung, in der eine Targethülse auf den Träger axial aufgeschoben ist.

Die Hauptteile der in ihrer Gesamtheit mit 1 bezeichneten Targetträgeranordnung sind ein Träger 2, der zum Beispiel durch eine im wesentlichen zylindrische Traghülse 3 gebildet sein kann, und eine Targethülse 4, die mit geringem Bewegungsspiel auf den Träger 2 aufschiebbar und darauf durch wenigstens ein Fixierelement in ihrer Umfangsrichtung und/oder in ihrer Achsrichtung fixiert ist.

Der Träger 2 besteht aus Metall, vorzugsweise Stahl. Er weist an seinen Enden bei L nur andeutungsweise dargestellte Befestigungsmittel auf, mit denen er in einem Drehlager um seine Mittelachse 2a drehbar gelagert ist, das Teil einer Vorrichtung zum Zerstäuben und Beschichten (Sputtern) auf einem nicht dargestellten ebenen Substrat z. B. Floatglas ist. Die Targethülse 3 besteht ebenfalls aus Metall.

Die axiale Länge L1 des Trägers 2 ist größer als die axiale Länge L2 der Targethülse 4, wobei Letztere im mittleren Bereich des Trägers 2 angeordnet ist, so daß dieser an beiden Enden den Träger 2 überragt.

Das durch einen radialen Pfeil verdeutlichte, wenigstens eine Fixierelement 5 ist ein elastisch wirksames Klemmelement 6, das beim Ausführungsbeispiel aus federelastischem Material besteht und eine zwischen dem Träger 2 und der Targethülse 4 radial wirksame Klemmspannung ausübt. Dabei kann es an der Targethülse 4 oder vorzugsweise am Träger 2 angeordnet sein, wie es das Ausführungsbeispiel zeigt.

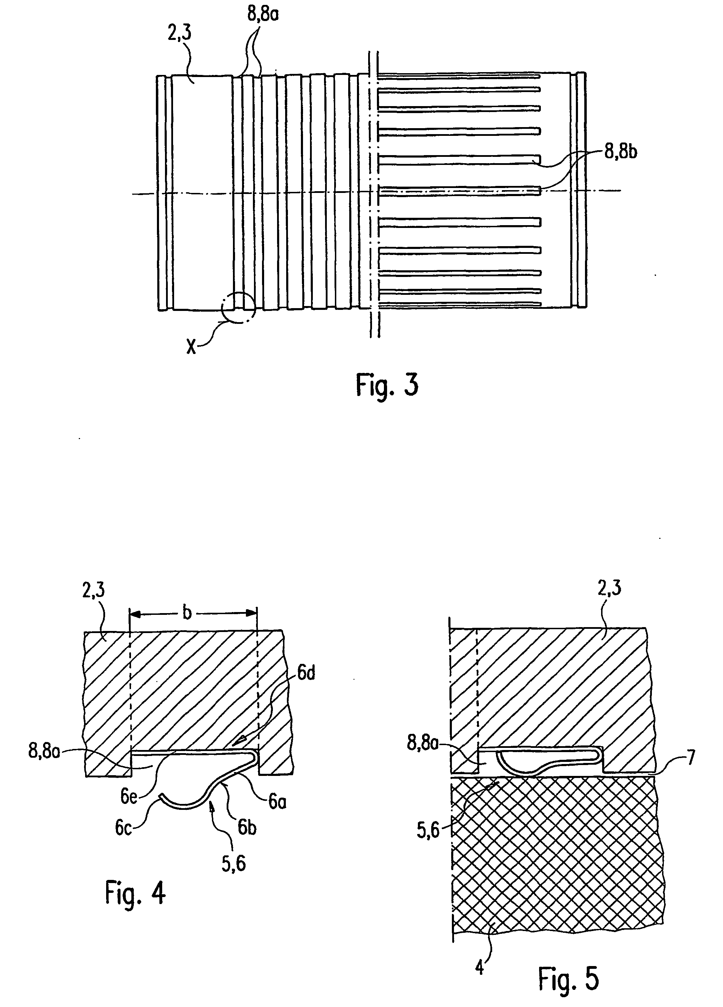

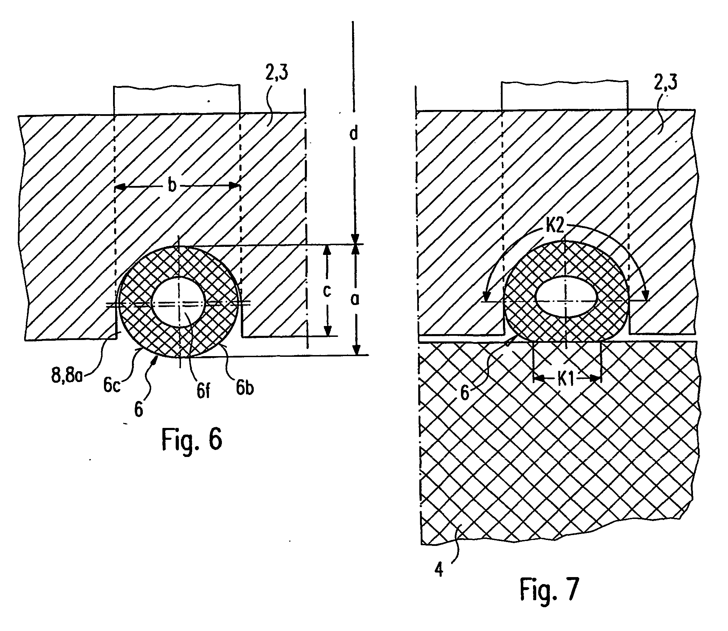

Wie insbesondere aus Fig. 4 und 5 zu entnehmen ist, weist das Klemmelement 6 einen Klemmschenkel 6a auf, der in seiner entspannten Freigabestellung gemäß Fig. 4 die zugehörige Mantelfläche bzw. hohlzylindrische Fuge 7 zwischen dem Träger 2 und der Targethülse 4 überragt. Beim Montieren der Traghülse 4 durch Aufschieben auf den Träger 2 wird der sich bezüglich der Fuge 7 schräg erstreckende und eine schräge oder gerundete Einführungskante 6b bildende Klemmschenkel 6a selbsttätig eingebogen, wobei er mit seiner dadurch erzeugten elastischen Biegespannung die radial wirksame elastische Spannung zwischen dem Träger 2 und der Targethülse 4 erzeugt, die die Fixierung gewährleistet. Es ist vorteilhaft, den Klemmschenkel 6a an seinem freien Ende mit einem sich entgegengesetzt schräg oder gerundet erstreckenden Einführungsschenkel 6c auszubilden, so daß das vorbeschriebene selbsttätige Einbiegen des Klemmschenkels 6a automatisch beim Aufschieben der Targethülse 4 wahlweise von der einen oder von der anderen Seite erfolgt.

Der Klemmschenkel 6a ist an seinem Basisende vorzugsweise einteilig mit einer Klemmelementbasis 6d verbunden, die in einer Ausnehmung 8 angeordnet und darin fixiert ist, zum Beispiel durch eine nicht dargestellte Schraube. Vorzugsweise ist die Klemmelementbasis 6d durch einen mit dem Klemmschenkel 6a verbundenen Basisschenkel 6e gebildet, der dadurch in der Ausnehmung 8 fixiert sein kann, daß seine Länge geringfügig größer bemessen ist, als die Breite b der Ausnehmung 8, so daß der Basisschenkel 6e zwischen den Seitenwänden der Ausnehmung 8 durch Eindrücken festgeklemmt ist.

Der Einführungsschenkel 6c kann so lang bemessen sein, daß sein freies Ende in der Klemmstellung an dem das Klemmelement 6 tragenden Teil, hier am Träger 2 oder am Grund der Ausnehmung 8 oder am Basisschenkel 6d, abgestützt ist, wie es Fig. 5 zeigt. Hierdurch läßt sich die Klemmkraft des Klemmelements 6 vergrößern. Das Klemmelement 6 ist vorzugsweise durch eine winkelförmige Feder, insbesondere Blattfeder, gebildet.

Das Klemmelement 6 kann nicht nur die Fixierfunktion sondern auch der Wärmeableitung von der Targethülse 4 zum Träger 2 hin und/oder der elektrischen Leitung zwischen dem Träger 2 und der Targethülse 4 dienen, wenn es aus wärmeleitfähigem Material und/oder aus elektrisch leitfähigem Material besteht.

Zwecks Vergrößerung der Fixierungskräfte und/oder der Wärmeableitung und/oder der elektrischen Leitung ist es vorteilhaft, mehrere Klemmelemente 6 anzuordnen, die vorzugsweise auf dem gesamten Umfang verteilt sind, so daß sich eine im wesentlichen auf dem gesamten Umfang verteilte Funktion ergibt.

Eine oder mehrere Ausnehmungen 8 können jeweils durch eine oder mehrere sich in Umfangsrichtung erstreckende Ringnuten 8a oder eine oder mehrere sich in der Achsrichtung 2a erstreckende Längsnuten 8b gebildet sein, wobei jeweils mehrere solcher Nuten 8a, 8b im Bereich der Targethülse 4 axial oder in Umfangsrichtung etwa gleichmäßig verteilt angeordnet sein können. Es ist auch möglich, ein oder mehrere auf dem Umfang verteilt angeordnete wendelförmige Nuten vorzusehen (nicht dargestellt).

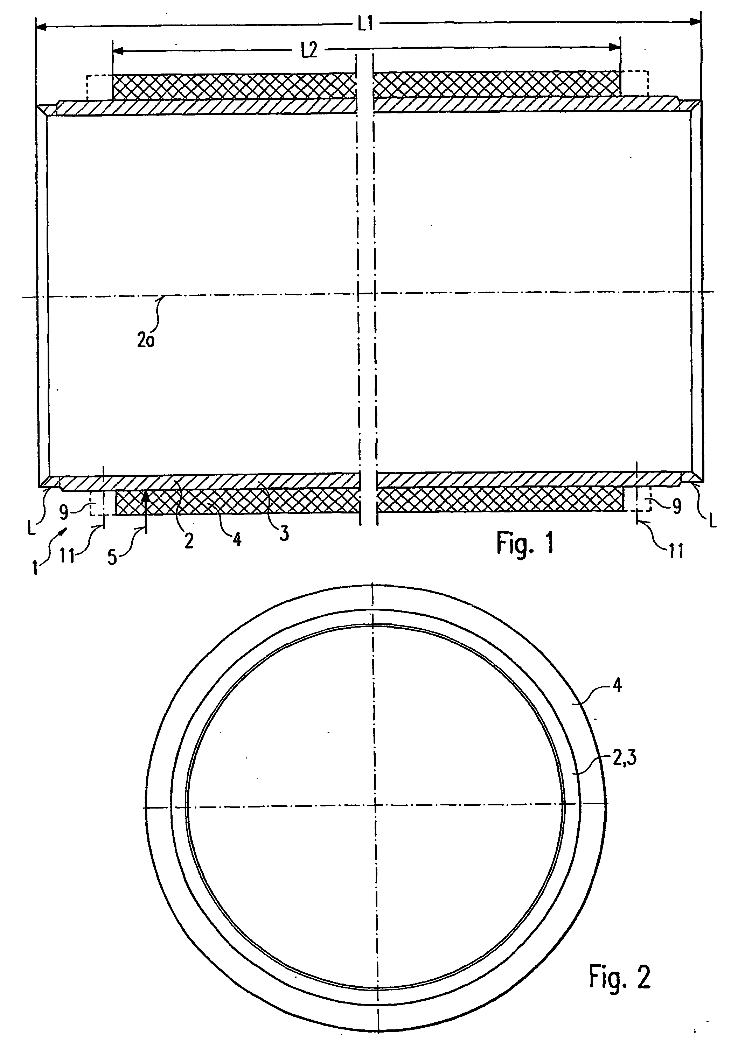

Wie es Fig. 1 zeigt, können zur gegebenenfalls zusätzlichen axialen Fixierung an den Enden der Targethülse 4 vorzugsweise ringförmige Begrenzungsteile 9 auf dem Träger 2 sitzen und damit lösbar verbunden sein, zum Beispiel durch andeutungsweise dargestellte Schrauben 11 verschraubt sein, die eine axiale Fixierung der Targethülse 4 auf dem Träger 2 bewirken.

Das Ausführungsbeispiel nach Fig. 6 und 7, bei dem gleiche oder vergleichbare Teile mit gleichen Bezugszeichen versehen sind, zeigt ein Klemmelement oder eine Klemmelementanordnung in abgewandelter Ausgestaltung, die aus mehreren Gründen vorteilhaft ist.

Ein erster Unterschied zum vorbeschriebenen Ausführungsbeispiel besteht darin, daß dieses Klemmelement 6 aus so elastisch verformbarem und/oder elastisch komprimierbarem Material besteht, daß es sich aufgrund seiner radialen Klemmspannung sowohl an die Targethülse als auch an den Träger flächig anlegt und dadurch jeweils eine große Kontaktfläche bildet, an der die elektrische Leitung und die Wärmeableitung erfolgen.

Die Wärmeleitfähigkeit und elektrische Leitfähigkeit des elastisch verformbaren oder elastisch komprimierbaren Materials des Klemmelements 6 kann durch ein Einbetten von Partikeln oder Fasern aus elektrisch leitfähigem und wärmeleitendem Material, insbesondere aus Metall oder Kohlenstoff erfolgen, wobei das elastische Basismaterial aus Kunststoff, insbesondere Silikon, bestehen kann.

Beim Ausführungsbeispiel weist das Klemmelement 6 die Form eines offenen oder geschlossenen Ringes auf und es befindet sich in einer ringförmigen Ausnehmung 8, z. B. eine Ringnut. Dabei ist die radiale Abmessung a des Klemmelements 6 im radial entspannten Zustand größer als die radiale Abmessung c der Ausnehmung 8, so daß das Klemmelement die Ausnehmung 8 überragt und beim Aufschieben der Targethülse 4 in die Form gemäß Fig. 7 zusammengedrückt wird, in der es unter der radialen Spannung radial verformt und ggf. auch komprimiert ist. Die axiale Abmessung der Kontaktfläche K1, mit der das Klemmelement 6 an der Targethülse 4 anliegt, ist beträchtlich groß, und zwar insbesondere dann, wenn das Klemmelement in vorbeschriebener Weise ringförmig ausgebildet ist, da in diesem Fall die Kontaktfläche K1 sich auch über einen Großteil oder über den gesamten Umfang erstreckt.

Aufgrund der radialen Klemmspannung liegt das Klemmelement auch an der Grundfläche der Ausnehmung 8 flächig an. Diese Fläche kann weiter vergrößert werden, wenn sie im axialen Schnitt gerundet ist. Beim Ausführungsbeispiel ist der Ausnehmungsgrund konkav gerundet und das Klemmelement 6 entsprechend konvex gerundet. Dabei ist es vorteilhaft, das Klemmelement 6 mit einer solchen Breite auszubilden, daß es unter der radialen Klemmspannung auch an den Seitenwänden der Ausnehmung 8 anliegt, wodurch die Kontaktfläche K2 weiter vergrößert wird, was erwünscht ist. Beim Ausführungsbeispiel ist das Klemmelement 6 durch einen im Querschnitt runden Ring gebildet, dessen Innendurchmesser d dem Innendurchmesser des Ringnutgrundes entspricht oder etwas kleiner bemessen ist, so daß der so gebildete Klemmring mit einer elastischen Spannung am Ringnutgrund anliegt. Aufgrund der Ringform ist das Klemmelement 6 auch unverlierbar gehalten.

Beim Ausführungsbeispiel ist das Klemmelement 6 ein Hohlkörper mit einen zentralen Hohlraum 6f. Wenn das Klemmelement 6 ein Klemmring ist, kann es durch einen endlosen Schlauch gebildet sein, insbesondere einen dickwandigen Schlauch, dessen Wanddicke etwa ein Viertel seiner Querschnittsabmessung betragen kann.

Die zumindest außen gerundete Form des Klemmelements 6 ist vorteilhaft, weil sie beidseitig Einführungsflächen 6b, 6c bildet, die beim Aufschieben der Targethülse bzw. Einschieben des Trägers 2 selbsttätig ein Verdrängen des Klemmelements 6 in die Ausnehmung 8 ermöglichen.

Die Elastizität des Klemmelements 6 ist bei dessen Ausbildung in geschlossener Ringform so groß, daß es zu seiner Montage bzw. Demontage über den Außendurchmesser des Trägers 2 gestreckt werden kann und sich in der Ringnut 8a selbsttätig zum Nutgrund kontrahiert, vorzugsweise so weit, daß es mit einer Kontraktionsspannung am Nutgrund anliegt.

## Patentansprüche

1. Targetträgeranordnung (1) mit einer Traghülse (2), auf der ein Targetmantel angeordnet ist, der durch eine Targethülse (4) gebildet ist, die auf der Traghülse (2) aufgeschoben ist oder in die die Traghülse (4) eingeschoben ist, wobei zwischen der Traghülse (2) und der Targethülse (4) wenigstens ein Klemmelement (6) klemmend wirksam angeordnet ist,
**dadurch gekennzeichnet,**
**daß** mehrere elastisch wirksame Klemmelemente (6) vorgesehen sind, die auf dem Umfang verteilt angeordnet sind und jeweils durch eine Feder gebildet sind, die in einer Ausnehmung (8) in der Innenmantelfläche der Targethülse (4) oder in der Außenmantelfläche der Traghülse (2) unverlierbar am sie tragenden Teil (Traghülse bzw. Targethülse) angeordnet sind und elastisch gegen die ihnen gegenüberliegende Außenmantelfläche bzw. Innenmantelfläche drücken.

2. Targetträgeranordnung nach Anspruch 1,
**dadurch gekennzeichnet,**
**daß** die Klemmelemente (6) an einer oder an beiden in die Achsrichtung weisenden Seiten gerundete oder schräge Einführungskanten (6b, 6c) aufweisen.

3. Targetträgeranordnung nach Anspruch 1 oder 2,
**dadurch gekennzeichnet,**
**daß** die Klemmelemente (6) zur Ausübung ihres Klemmdrucks jeweils einen Klemmschenkel (6a) aufweisen, der mit seinem freien Endbereich den Klemmdruck ausübt.

4. Targetträgeranordnung nach Anspruch 3,
**dadurch gekennzeichnet,**
**daß** am freien Ende des Klemmschenkels (6a) ein Einführungsschenkel (6c) angeordnet ist, der mit dem Klemmschenkel (6a) eine winkelförmige oder gerundete Dachform bildet.

5. Targetträgeranordnung nach Anspruch 4,
**dadurch gekennzeichnet,**
**daß** das freie Ende des Einführungsschenkels (6c) in der Klemmstellung entgegen der Klemmspannung abgestützt ist.

6. Targetträgeranordnung nach einem der vorhergehenden Ansprüche,
**dadurch gekennzeichnet,**
**daß** die Klemmelemente (6) zwischen den Seitenwänden einer Ausnehmung (8) eingeklemmt sind.

7. Targetträgeranordnung nach einem der vorhergehenden Ansprüche 3 bis 6,
**dadurch gekennzeichnet,**
**daß** die Klemmelemente (6) jeweils durch eine winkelförmige Feder, insbesondere eine winkelförmige Blattfeder, mit dem Klemmschenkel (6a) und einem Basisschenkel (6e) gebildet sind.

8. Targetträgeranordnung nach Anspruch 7,
**dadurch gekennzeichnet,**
**daß** der Basisschenkel (6e) zwischen den Seitenwänden der Ausnehmung (8) eingeklemmt ist.

9. Targetträgeranordnung nach Anspruch 8,
**dadurch gekennzeichnet,**
**daß** eine oder mehrere Ausnehmungen (8) in Form von sich in die Umfangsrichtung oder Achsrichtung oder wendelförmig erstreckenden Nuten (8a, 8b) gebildet ist bzw. sind.

10. Targetträgeranordnung nach Anspruch 9,
**dadurch gekennzeichnet,**
**daß** die sich in die Umfangsrichtung erstreckende Nut bzw. Nuten jeweils durch eine Ringnut gebildet ist bzw. sind.

11. Targetträgeranordnung nach einem der vorhergehenden Ansprüche,
**dadurch gekennzeichnet,**
**daß** die Klemmelemente (6) jeweils aus elastisch verformbarem und/oder elastisch komprimierbarem Material bestehen.

12. Targetträgeranrodnung nach Anspruch 11,
**dadurch gekennzeichnet,**
**daß** die Klemmelemente (6) aus Kunststoff bestehen und daß im Material der Klemmelemente (6) Partikel oder Fasern aus elektrisch leitendem und/oder wärmeleitendem Material eingebettet sind.

13. Targetträgeranordnung nach Anspruch 3 und einem der Ansprüche 15 bis 16,
**dadurch gekennzeichnet,**
**daß** die Klemmelemente (6) wenigstens im Bereich einer Öffnung der Ausnehmung (8) eine - quer zur Achsrichtung des Trägers gesehen - konvexe, insbesondere gerundete, Form aufweisen.

14. Targetträgeranordnung nach Anspruch 13,
**dadurch gekennzeichnet,**
**daß** die Klemmelemente (6) und die Ausnehmung (8) ringförmig ausgebildet sind.

15. Targetträgeranordnung nach Anspruch 14,
**dadurch gekennzeichnet,**
**daß** die Klemmelemente (6) jeweils wenigstens an ihrer Innenseite eine konvex gerundete Querschnittsform aufweisen und vorzugsweise der Ausnehmungsgrund entsprechend gerundet ist.

16. Targetträgeranordnung nach einem der vorhergehenden Ansprüche,
**dadurch gekennzeichnet,**
**daß** die Länge (L1) der Traghülse (2) größer ist als die Länge (L2) der Targethülse (4) und auf der Traghülse (2) an einem oder an beiden Enden der Targethülse (4) jeweils wenigstens ein ringförmiges Begrenzungsteil (9) lösbar befestigt ist.

## Claims

1. Target support assembly (1), comprising a support sleeve (2) on which is arranged a target lining that is formed by a target sleeve (4) that is slid on to the support sleeve (2) or into which the support sleeve (4) is slid, at least one clamping element (6) being arranged to be clampingly effective between the support sleeve (2) and the target sleeve (4),
**characterised in**
**that** a plurality of elastically active clamping elements (6) are provided which are distributed around the circumference and are formed in each case by a spring, and which are arranged in a recess (8) in the internal cylindrical surface of the target sleeve (4) or in the external cylindrical surface of the support sleeve (2) in a captive manner on the part carrying them (support sleeve or target sleeve) and press elastically against the external cylindrical surface or internal cylindrical surface located opposite said clamping elements (6).

2. Target support assembly according to claim 1,
**characterised in**
**that** the clamping elements (6) have rounded or oblique insertion edges (6b, 6c) on both sides facing in the axial direction.

3. Target support assembly according to claim 1 or 2,
**characterised in**
**that** to exert their clamping pressure the clamping elements (6) have in each case a clamping arm (6a) that exerts the clamping pressure with its free end portion.

4. Target support assembly according to claim 3,
**characterised in**
**that** an insertion segment (6c) is arranged at the free end of the clamping arm (6a) and forms an angled or rounded roof-shaped element with the clamping arm (6a).

5. Target support assembly according to claim 4,
**characterised in**
**that** the free end of the insertion segment (6c) is supported against the clamping stress in the clamping position.

6. Target support assembly according to any one of the preceding claims,
**characterised in**
**that** the clamping elements (6) are wedged between the side walls of a recess (8).

7. Target support assembly according to any one of the preceding claims 3 to 6,
**characterised in**
**that** the clamping elements (6) are in each case formed by an angled spring, in particular an angled leaf spring, comprising the clamping arm (6a) and a base arm (6e).

8. Target support assembly according to claim 7,
**characterised in**
**that** the base arm (6e) is wedged between the side walls of the recess (8).

9. Target support assembly according to claim 8,
**characterised in**
**that** one or more recesses (8) is/are formed as grooves (8a, 8b) extending in the circumferential or axial direction or helically.

10. Target support assembly according to claim 9,
**characterised in**
**that** the groove or grooves extending in the circumferential direction is/are formed in each case by an annular groove.

11. Target support assembly according to any one of the preceding claims,
**characterised in**
**that** the clamping elements (6) are in each case made of elastically deformable and/or elastically compressible material.

12. Target support assembly according to claim 11,
**characterised in**
**that** the clamping elements (6) are made of synthetic material and in that particles or fibres of electrically and/or thermally conductive material are embedded in the material of the clamping elements (6).

13. Target support assembly according to claim 3 and either of claims 15 and 16,
**characterised in**
**that** the clamping elements (6) have, at least in the area of an opening of the recess (8), a shape that is convex, in particular rounded, viewed transversely to the axial direction of the support.

14. Target support assembly according to claim 13,
**characterised in**
**that** the clamping elements (6) and the recess (8) have an annular configuration.

15. Target support assembly according to claim 14,
**characterised in**
**that** the clamping elements (6) have in each case, at least on their inner side, a convexly rounded cross-sectional form and the base of the recess is preferably rounded correspondingly.

16. Target support assembly according to any one of the preceding claims,
**characterised in**
**that** the length (L1) of the support sleeve (2) is greater than the length (L2) of the target sleeve (4) and at least one annular limiting part (9) is fixed detachably on the support sleeve (2) at one or both ends of the target sleeve (4).

## Revendications

1. Dispositif porte-cible (1) comportant une douille de support (2), sur laquelle est disposée une enveloppe de cible, qui est formée par une douille de cible (4) et est emmanchée sur la douille de support (2) ou dans laquelle est enfoncée la douille de cible (4), au moins un élément de serrage (6) étant disposé de manière à réaliser un serrage entre la douille de support (2) et la douille de cible (4),
**caractérisé en ce que**
qu'il est prévu plusieurs éléments de serrage à action élastique (6), qui sont disposés d'une manière répartie sur la périphérie et sont formés par des ressorts respectifs, qui sont disposés dans un évidement (8) formé dans la surface enveloppe intérieure de la douille de cible (4) ou dans la surface enveloppe extérieure de la douille de support (2) d'une manière imperdable, sur la partie, qui les porte (douille de support ou douille de cible) et appuient élastiquement contre la surface enveloppe extérieure ou contre la surface enveloppe intérieure, qui est située en vis-à-vis de ces surfaces.

2. Dispositif porte-cible selon la revendication 1, **caractérisé en ce que** les éléments de serrage (6) possèdent, sur un côté ou sur les deux côtés tournés dans la direction axiale, des arêtes d'introduction arrondies ou obliques (6d, 6c).

3. Dispositif porte-cible selon la revendication 1 ou 2, **caractérisé en ce que** les éléments de serrage (6) possèdent, pour appliquer leur pression de serrage, respectivement une branche de serrage (6a), qui applique la pression de serrage au moyen de sa partie d'extrémité libre.

4. Dispositif porte-cible selon la revendication 3, **caractérisé en ce que** sur l'extrémité libre de la branche de serrage (6a) est disposée une branche d'introduction (6c), qui forme avec la branche de serrage (6a) une forme de toit anguleuse ou arrondie.

5. Dispositif porte-cible selon la revendication 4, **caractérisé en ce que** l'extrémité libre de la branche d'introduction (6c) est supportée dans la position de serrage à l'encontre de la contrainte de serrage.

6. Dispositif porte-cible selon l'une des revendications précédentes, **caractérisé en ce que** les éléments de serrage (6) sont serrés entre des parois latérales d'un évidement (8).

7. Dispositif porte-cible selon l'une des revendications précédentes 3 à 6, **caractérisé en ce que** les éléments de serrage (6) sont formés respectivement par un ressort de forme coudée, notamment un ressort à lame coudée, comportant une branche de serrage (6a) et une branche de base (6e).

8. Dispositif porte-cible selon la revendication 7, **caractérisé en ce que** la branche de base (6e) est serrée entre les parois latérales de l'évidement (8).

9. Dispositif porte-cible selon la revendication 8, **caractérisé en ce qu'**un ou plusieurs évidements (8) sont formés sous la forme de rainures (8a, 8b), qui s'étendent dans la direction périphérique ou dans la direction d'axe ou sous une forme hélicoïdale.

10. Dispositif porte-cible selon la revendication 9, **caractérisé en ce que** la ou les rainures, qui s'étendent dans la direction périphérique, est ou sont formées respectivement par une rainure annulaire.

11. Dispositif porte-cible selon l'une des revendications précédentes, **caractérisé en ce que** les éléments de serrage (6) sont constitués chacun par un matériau déformable élastiquement et/ou pouvant être comprimés élastiquement.

12. Dispositif porte-cible selon la revendication 11, **caractérisé en ce que** les éléments de serrage (6) sont réalisés en matière plastique et que des particules ou des fibres formées d'un matériau électriquement conducteur et/ou thermoconducteur sont insérées dans le matériau des éléments de serrage (6).

13. Dispositif porte-cible selon la revendication 3 et l'une des revendications 15 à 16, **caractérisé en ce que** les éléments de serrage (6) possèdent au moins dans la zone d'une ouverture de l'évidement (8) une forme convexe - vue transversalement par rapport à la direction axiale du support -, notamment arrondie.

14. Dispositif porte-cible selon la revendication 13, **caractérisé en ce que** les éléments de serrage (6) et l'évidement (8) sont réalisés avec une forme annulaire.

15. Dispositif porte-cible selon la revendication 14, **caractérisé en ce que** les éléments de serrage (6) possèdent chacun au moins sur leur face intérieure une forme en coupe transversale arrondie convexe et que de préférence le fond de l'évidement possède une forme arrondie correspondante.

16. Dispositif porte-cible selon l'une des revendications précédentes, **caractérisé en ce que** la longueur (L1) de la douille de support (2) est supérieure à la longueur (L2) de la douille de cible (4) et que respectivement au moins une partie de limitation de forme annulaire (9) est fixée de façon amovible sur une extrémité ou sur les deux extrémités de la douille de cible (4).
